(19) Europäisches Patentamt
European Patent Office
Office européen des brevets

(11) **EP 4 686 039 A1**

(12) **EUROPEAN PATENT APPLICATION**

(43) Date of publication:
**28.01.2026 Bulletin 2026/05**

(51) International Patent Classification (IPC):
***H02J 7/00*** (2026.01)          ***B60L 58/22*** (2019.01)
***H01B 7/08*** (2006.01)

(21) Application number: **25180851.5**

(22) Date of filing: **04.06.2025**

(52) Cooperative Patent Classification (CPC):
**H02J 7/0016; B60L 58/22**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **25.07.2024 KR 20240098351**

(71) Applicant: **SAMSUNG SDI CO., LTD.**
**Yongin-si, Gyeonggi-do 17084 (KR)**

(72) Inventor: **KIM, Tae Jin**
**16678 Suwon-si (KR)**

(74) Representative: **Marks & Clerk LLP**
**15 Fetter Lane**
**London EC4A 1BW (GB)**

(54) **CELL BALANCING CURRENT CONTROL DEVICE AND METHOD, AND BATTERY PACK**

(57)     A cell balancing current control device and method for a battery pack are capable of reflecting a resistance value depending on a length of a flat cable (200) which connects each cell (105, cell 1 to 6) of a multi-series battery (100) and a battery management system, BMS (300), (that is, cell to BMS connection) to control an on/off duty ratio of a switching module (320) for applying a cell balancing current to be different for each individual cell (105, cells 1 to 6), and a battery pack. Cell balancing current control is based on an on/off duty of a switching module (320) calculated by reflecting the resistance value depending on the length of the flat cable (200).

FIG.3

EP 4 686 039 A1

**Description**

**FIELD**

The present disclosure relates to a cell balancing current control device and method and a battery pack.

**BACKGROUND**

Generally, when a multi-series battery is configured, a difference in cell voltage occurs during charging and discharging, a cell balancing operation is performed so as to improve this, and in this case, a cell balancing current is set by considering resistance and a temperature of an internal switch, and there is no difference for each individual cell.

**SUMMARY**

According to some embodiments, a cell balancing current control device and method are provided to account for a resistance value depending on a length of a flat cable which connects each cell of a multi-series battery and a battery management system (BMS) (that is, cell to BMS connection) to control an on/off duty ratio of a switching module for applying a cell balancing current to be different for each individual cell, and a battery pack.

In a cell balancing current control device of a battery cell connected to a battery management system (BMS) with a flat cable according to some embodiments, the BMS includes at least one processor, and the processor reflects a resistance value depending on a length of the flat cable to control an on/off duty of a switching module for controlling a cell balancing current for each individual cell.

According to a first aspect of the present invention there is provided a cell balancing current control device of cells of a battery implemented by a battery management system (BMS) connected to the cells with a flat cable, the cell balancing current control device comprising:

a switching module for controlling a cell balancing current for each cell; and
at least one processor configured to use a resistance value of the flat cable that depends on a length of the flat cable to control an on/off duty of the switching module, for each individual cell.

In some embodiments, the flat cable includes a plurality of taps for connecting to cells of the battery at respective designated intervals; and
there is a difference in resistance value associated with each tap depending on a cable length from a connector to each tap of the flat cable.

In some embodiments, the cell balancing current control device further comprises:

a resistor module including a plurality of balancing resistors ($RS_1$ to $RS_n$), wherein each of the balancing resistors ($RS_1$ to $RS_n$) has a resistance value (X) set for applying a cell balancing current; and
a switching module including a plurality of balancing switches ($SW_1$ to $SW_n$) between the at least one processor and the flat cable configured to control the cell balancing current .

In some embodiments, the processor reflects a resistance value (X) of each balancing resistor ($RS_1$ to $RS_n$) of a resistor module, the resistance value depending on the length of the flat cable to each tap, to control the cell balancing current through control of the on/off duty of each balancing switch ($SW_1$ to $SW_n$) of a switching module.

In some embodiments, the processor calculates a duty (New duty) for cell balancing current control for each cell to which the flat cable is connected, and reflects the resistance value of the flat cable, which depends on the length of the flat cable to which each cell is connected, to calculate the duty (New duty) for each cell.

In some embodiments, the processor calculates the duty (New duty) for each cell as:

$$\text{New duty} = (X + \text{FlatCable R})/X * \text{duty},$$

where, X is a resistance value of each balancing resistor ($RS_1$ to $RS_n$) that reflects the resistance value of the flat cable associated with each balancing resistor ($RS_1$ to $RS_n$),
FlatCable R is the resistance value of the flat cable based on the length of the flat cable , and
duty is a duty value that does not reflect the resistance value of the flat cable.

In some embodiments, in order to control the cell balancing current for each cell to which the flat cable is connected, the processor calculates a duty (New duty) for each cell that reflects the resistance value depending on the length of the flat cable to which each cell is connected, and reflects a resistance value (X) of each balancing resistor ($RS_1$ to $RS_n$) connected to each cell and a resistance value (FlatCable R) depending on the length of the flat cable to control the cell balancing current.

In some embodiments, the processor controls each cell balancing current according to:

$$\text{cell balancing current} = (V/(X+\text{FlatCable R}))*\text{New duty}$$

where, V is a cell voltage,
X is the resistance value of each balancing resistor ($RS_1$ to $RS_n$),
FlatCable R is the resistance value of the flat cable, and
New duty is a duty value reflecting the resistance value of the flat cable.

According to a further aspect of the present invention there is provided a cell balancing current control method for cells of a battery connected to a battery management system (BMS) with a flat cable, the cell balancing current control method comprising:

reflecting, by a processor of the BMS, a resistance value depending on a length of the flat cable to calculate an on/off duty of a switching module; and
performing, by the processor, cell balancing current control based on the on/off duty of the switching module calculated by reflecting the resistance value depending on the length of the flat cable.

In some embodiments, in the reflecting of the resistance value depending on the length of the flat cable,

the flat cable includes a plurality of taps for connecting cells of the battery at respective designated intervals, and
there is a difference in resistance value depending on a cable length from a connector to each tap of the flat cable.

In some embodiments, a resistor module including a plurality of balancing resistors ($RS_1$ to $RS_n$) each having a resistance value (X) set for applying a cell balancing current and a switching module including a plurality of balancing switches ($SW_1$ to $SW_n$) for controlling the cell balancing current are formed between the processor and the flat cable.

In some embodiments, in the performing of the cell balancing current control, the processor reflects a resistance value (X) of each balancing resistor ($RS_1$ to $RS_n$) of a resistor module and the resistance value depending on a length to each tap of the flat cable to control the cell balancing current through the on/off duty control of each balancing switch ($SW_1$ to $SW_n$) of a switching module.

In some embodiments, the method further comprises calculating the on/off duty of the switching module by calculating a duty (New duty) for the cell balancing current control for each cell to which the flat cable is connected, and reflecting the resistance value depending on the length of the flat cable to which each cell is connected.

In some embodiments, calculating the duty (New duty) for each cell is according to:

$$\text{duty (New duty)}=(X+\text{FlatCable R})/X*\text{duty},$$

where, X is a resistance value of each balancing resistor ($RS_1$ to $RS_n$),
FlatCable R is a resistance value of the flat cable, and
duty is a duty value that does not reflect the resistance value of the flat cable.

In some embodiments, in the performing of the cell balancing current control, in order to control the cell balancing current for each cell to which the flat cable is connected, the processor calculates a duty (New duty) for each cell that reflects the resistance value depending on the length of the flat cable to which each cell is connected, and reflects a resistance value (X) of each balancing resistor ($RS_1$ to $RS_n$) connected to each cell and a resistance value (FlatCable R) depending on the length of the flat cable to control the cell balancing current.

In some embodiments, the method further comprises controlling each cell balancing current according to:
cell balancing current = (V/(X+FlatCable R))*New duty

where, V is a cell voltage,

X is a resistance value of each balancing resistor ($RS_1$ to $RS_n$),

FlatCable R is the resistance value (CR) of the flat cable, and

New duty is a duty value that does not reflect the resistance value of the flat cable.

The method may be carried out using the cell balancing current control device defined above.

According to a further aspect of the present invention there is provided a battery pack comprising:

a plurality of battery cells;

a battery management system (BMS); and

a flat cable that connects the BMS and each of the plurality of battery cells,

wherein at least one processor of the BMS performs cell balancing current control for each cell based on a duty calculated by reflecting a resistance value of the flat cable depending on a length of the flat cable.

The processor may be a cell balancing current control device defined above.

Aspects and features other than the above aspects and features will become apparent from the detailed description, claims, and/or drawings below.

## BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:

FIG. 1 illustrates a flat cable connection configuration between a battery management system (BMS) and a battery cell to which a cell balancing current control device is applied according to some embodiments;

FIG. 2 is a diagram illustrating resistance values that depend on a length of a flat cable connected to each cell of a battery of FIG. 1;

FIG. 3 illustrates a schematic configuration of the cell balancing current control device according to some embodiments;

FIG. 4 illustrates a waveform of an on/off duty control signal of a balancing switch ($SW_1$ to $SW_n$) of a switching module for controlling a cell balancing current by reflecting a resistance value (X) of a corresponding balancing resistor ($RS_1$ to $RS_n$) of a resistor module and a resistance value depending on the length to each tap of the flat cable of FIG. 3; and

FIG. 5 illustrate a process flow of a method for controlling the cell balancing current by reflecting the resistance value of the flat cable according to some embodiments.

## DETAILED DESCRIPTION

Hereinafter, embodiments are described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

Generally, a cell balancing operation is performed to account for a difference in cell voltage during charging and discharging. When each cell of the multi-series battery and a battery management system (BMS) are connected (that is, cell to BMS connection), a wire was conventionally used, but recently, a flat cable is being used.

However, when a flat cable (for example, a flexible printed circuit board (FPCB), a flexible flat cable (FFC), a flat drop cable (FDC), or the like) is used for the cell to BMS connection, a difference in resistance value depending on a length of the flat cable is large, and accordingly, a difference in cell balancing current also occurs. That is, there is a problem in that the cell balancing current decreases due to the resistance of the flat cable, which lowers the cell balancing efficiency. This decrease in cell balancing current may be different for each individual cell based on the length of the flat cable to the individual cell.

Accordingly, the inventors recognized that controlling a duty ratio of the cell balancing current to be different for each individual cell by reflecting the resistance value depending on the length of the flat cable can improve the cell balancing efficiency.

A battery pack may include at least one battery module and a pack housing in which an accommodation space which accommodates the at least one battery module therein is formed.

The battery module may include a plurality of battery cells and a module housing. The battery cells may be accommodated in the module housing in a stacked form. The battery cell may include a positive electrode lead and a negative electrode lead. Depending on a battery type, round-type, prismatic-type, or pouch-type battery cell may be used.

Instead of the battery module, one cell stack may constitute one module in the battery pack. The cell stack may be accommodated in the accommodation space of the pack housing or may be accommodated in an accommodation space partitioned by a frame, a partition, or the like.

The battery cells generate a large amount of heat during charging/discharging. The generated heat is accumulated in the battery cells and accelerates the deterioration of the battery cells. Accordingly, the battery pack may further include a cooling member to suppress the deterioration of the battery cells. The cooling member may be provided at the bottom of the accommodation space where the battery cells are provided, but is not limited thereto, and may be provided at the top or side depending on the battery pack.

The battery cell may discharge an exhaust gas in the battery cell generated under abnormal operating conditions, also known as a thermal runaway or thermal event, to the outside of the battery cell. The battery pack or battery module may include an exhaust port for discharging the exhaust gas to prevent damage to the battery pack or module.

According to some embodiments, the battery pack may include a battery and a battery management system (BMS) for managing the battery. The BMS may include a detection device, a balancing device, and a control device. The battery module may include a plurality of cells connected in series or parallel. The battery modules may be connected in series or parallel.

The detection device may detect state information which indicates the state of the battery by detecting a state (a voltage, a current, a temperature, and the like) of the battery. The detection device may detect a voltage of each cell or each battery module constituting the battery. The detection device may also detect a current flowing through the battery cell or each battery module constituting the battery pack. The detection device may also detect an ambient temperature of a cell and/or a module at least at one point of the battery.

The balancing device may perform a balancing operation of the battery module and/or cell constituting the battery. The control device may receive state information (a voltage, a current, a temperature, and the like) of the battery module from the detection device. The control device may monitor and calculate the state (a voltage, a current, a temperature, a state of charge (SOC), a state of health (SOH), and the like) of the battery module based on the state information received from the detection device. Further, the control device may perform control functions (for example, temperature control, balancing control, charging/discharging control, and the like), protection functions (for example, over-discharge, over-charge, over-current prevention, a short-circuit, a fire extinguishing function, and the like) based on the state monitoring results. In addition, the control device may perform a wired or wireless communication function with an external device of the battery pack (for example, an upper controller, a vehicle, a charger, a power conversion system (PCS), or the like).

The control device may control the charging/discharging operation and protection operation of the battery. To this end, the control device may include a charging/discharging control unit, a balancing control unit, and a protection unit.

According to some embodiments discussed herein, the battery management system is a system which monitors a battery state, performs diagnosis, control, communication, and protection functions, and may calculate a charging/-discharging state, calculate a lifespan or a state of health (SOH) of the battery, block battery power (relay control) as necessary, perform thermal management (cooling, heating, and the like) control, perform a high-voltage interlock function, and detect or calculate insulated and short-circuited states.

A relay may be a mechanical contactor turned on and off by a magnetic force of a coil, or a semiconductor switch such as a metal-oxide semiconductor field-effect transistor (MOSFET).

The relay control is a function of blocking power supply from the battery when a problem occurs in a vehicle and a battery system, and one or more relays and pre-charge relays may be configured at each of a positive terminal and a negative terminal.

Since pre-charge control has a risk of an inrush current occurring in a high-voltage capacitor at an input side of an inverter when a battery load is connected, in order to prevent the inrush current from being input, a function of connecting the pre-charge relay to a resistor for pre-charge by operating a pre-charge relay before connecting a main relay when a vehicle starts may be provided.

A high-voltage interlock is a circuit that detects, using a small signal to detect, whether all high-voltage components are connected to an entire vehicle system, and may have a function of forcibly opening a relay when an open occurs at any one location on an entire loop.

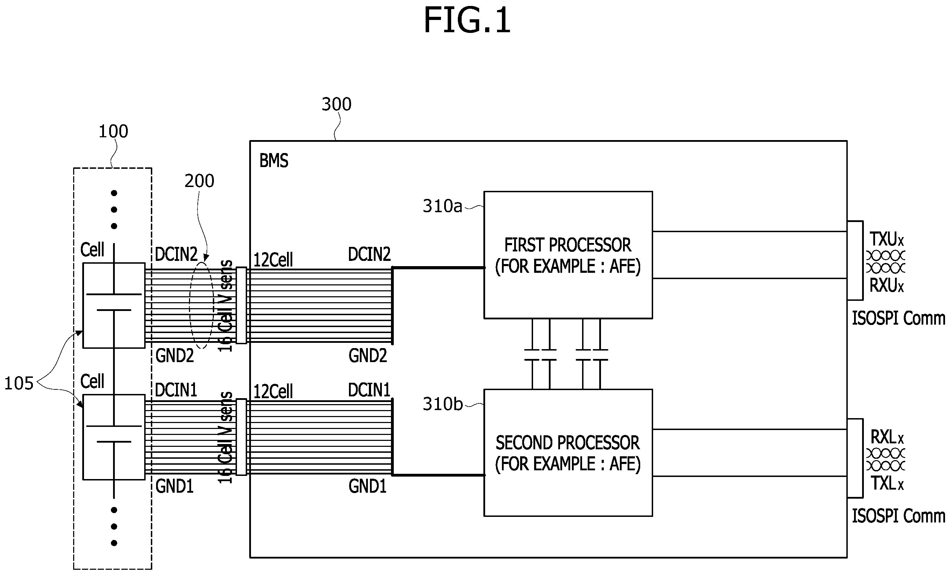

FIG. 1 is an diagram illustrating a flat cable connection configuration between a battery management system (BMS) 300 and a battery cell 105 to which a cell balancing current control device according to one embodiment of the present disclosure is applied, and/or to which cell balancing current control according to one or more embodiments is applied.

Referring to FIG. 1, a battery management system (BMS) 300 may include a plurality of processors 310a and 310b.

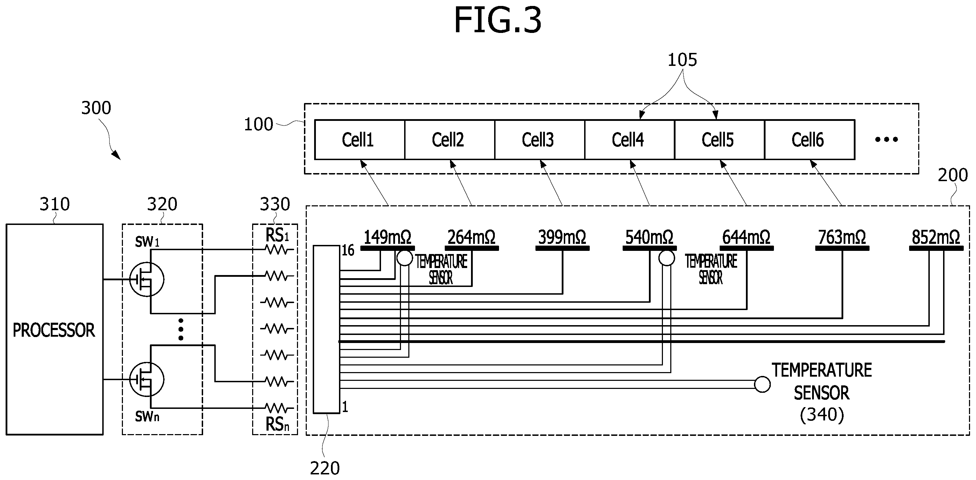

Each processor 310a and 310b (hereinafter, in the embodiment, 301a and 310b may be integrated and disclosed as a reference number 310 - see FIG. 3) may include an upper/lower analog front end (AFE) function. That is, each processor (310: 310a and 310b) may be understood as a broader concept including the upper/lower analog front end (AFE) function.

Each processor (310: 310a and 310b) is connected to a respective cell 105 of a battery 100 through a flat cable 200 (for example, a flexible printed circuit board (FPCB), a flexible flat cable (FFC), a flat drop cable (FDC), or the like).

In this case, the flat cable 200 has a difference in resistance value depending on a cable length (that is, a length of the flat cable 200 connected to each cell 105 of the battery 100).

Thus, a difference in cell balancing current is needed in the flat cable 200 in response to the difference in resistance value (that is, a cable resistance value) depending on the cable length.

For example, assuming that the same cell balancing current is applied to each cell 105 of the battery 100, since the resistance value (that is, the cable resistance value) increases as the cable length increases, the cell balancing current decreases, and thus the cell balancing efficiency is lowered. This decrease may be different for each cell 105 based on cable length to the cell 105.

Accordingly, by the processor 310 (310a and 310b) controlling an on/off duty ratio of a switching module 320 (FIG. 3) for controlling a cell balancing current to be different for each individual cell 105 to reflect the resistance value depending on the length of the flat cable 200 which connects each cell 105 of the battery 100 and the BMS 300, the cell balancing efficiency is improved.

That is, according to some embodiments, by the processor (310: 310a, 310b) controlling a ratio (a duty ratio) of a charging time and a bypass time of each cell 105 of the battery 100, and by controlling a current supplied to each cell 105 of the battery 100 to perform cell balancing based on the resistance value (that is, the cable resistance value) that depends on the length of the flat cable 200 which connects each cell 105 of the battery 100 and the BMS 300, the cell balancing efficiency is improved.

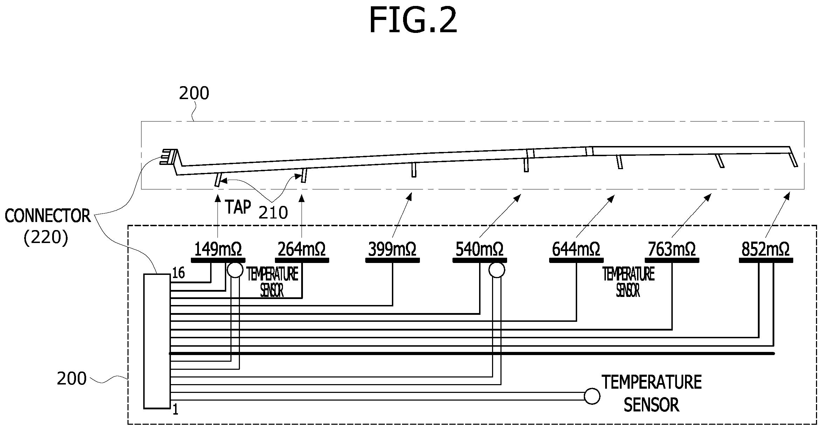

FIG. 2 is an diagram for describing a resistance value depending on the length of the flat cable 200 connected to each cell 105 of the battery 100 in FIG. 1.

Referring to FIG. 2, the flat cable 200 is formed with a plurality of taps 210 for connecting each cell 105 of the battery 100 at predetermined intervals.

Accordingly, the resistance value differs depending on the cable length from a connector 220 to each tap 210 of the flat cable 200.

For example, it can be seen that a resistance value from the connector 220 to a first tap 210 of the flat cable 200, closest to the connector 220, is in this example 149 m$\Omega$ and a resistance value from the connector 220 to the last tap 210 of the flat cable 200, farthest from the connector 220, increases in this example to 852 m$\Omega$. Similarly, it can be seen that the resistance value also increases (for example, 264 m$\Omega$, 399 m$\Omega$, 540 m$\Omega$, 644 m$\Omega$, 763 m$\Omega$, and the like in this example) in response to the cable length as the length from the connector 220 to each tap 210 of the flat cable 200 increases.

It should be understood that the resistance values to each tap 210 of the flat cable 200 shown in FIG. 2 are provided for explanatory purposes and are not intended to be limiting.

Further, it should be noted that the resistance value for each length of the flat cable 200 may differ depending on the thickness and width of the flat cable 200.

For reference, the flat cable 200 may include a plurality of temperature sensors 340 (FIG. 3), and the connector 220 may include terminals connected to the plurality of temperature sensors 340.

As described above, it can be seen that there is a difference in resistance value depending on the schematic shape and length of the flat cable 200 (that is, the length from the connector 220 to each tap 210 for connecting each cell 105 of the battery 100).

FIG. 3 is an diagram illustrating a schematic configuration of the cell balancing current control device, which may be implemented by aspects of the BMS 300 according to some embodiments of the present disclosure. As illustrated, each cell 105 of the battery 100 and the processor 310 of the BMS 300 are connected through the flat cable 200.

In this case, the connector 220 of the flat cable 200 is connected to the BMS 300, and a switching module 320 and a resistor module 330 are included between the processor 310 of the BMS 300 and the connector 220.

Here, the processor 310 may include an analog front end (AFE) function. That is, the processor 310 may be understood as a broader concept including the analog front end (AFE) function.

Referring to FIG. 3, each cell 105 of the battery 100 is connected through the tap 210 (as shown in FIG. 2) formed at each designated length (or interval) of the flat cable 200.

In this case, the resistance value differs depending on the length from the connector 220 to each tap 210 of the flat cable 200. As previously noted, conventionally, cell balancing is performed without considering the difference in resistance value depending on a length to each tap 210 of the flat cable 200. According to embodiments related to the cell balancing current control functionality of the BMS 300, the different resistance values are taken into account.

The resistor module 330 includes a plurality of balancing resistors $RS_1$ to $RS_n$ having resistance values X set for applying the maximum cell balancing current.

According to some embodiments, the resistance value X of each balancing resistor $RS_1$ to $RS_n$ of the resistor module 330 is a resistance value that reflects a (different) resistance value based on the length to each tap 210 of the flat cable 200. That is, the resistance value X of a given balancing resistor $RS_1$ to $RS_n$ reflects the resistance of the flat cable 200 (FlatCable resistance R) associated with the balancing resistor $RS_1$ to $RS_n$, which in turn is based on the length of the flat cable 200 associated with the balancing resistor $RS_1$ to $RS_n$.

The switching module 320 includes a plurality of balancing switches $SW_1$ to $SW_n$ for controlling the cell balancing current.

The processor 310 controls an on/off duty of each balancing switch $SW_1$ to $SW_n$ of the switching module 320 to control the cell balancing current.

That is, each balancing switch $SW_1$ to $SW_n$ of the switching module 320 controls the on/off duty ratio for each individual cell 105 depending on control of the processor 310. Accordingly, control of the switches $SW_1$ to $SW_n$ may be different and the cell balancing efficiency may be improved. According to some embodiments, the processor 310 adjusts the ratio (the duty ratio) of the charging time and the bypass time of each cell 105 of the battery 100, and controls the current supplied to each cell 105 of the battery 100 to perform cell balancing by reflecting the resistance value (that is, the cable resistance value) depending on the length of the flat cable 200 to the cell 105.

Here, each balancing switch $SW_1$ to $SW_n$ may include a semiconductor switch such as a metal-oxide semiconductor field effect transistor (MOSFET).

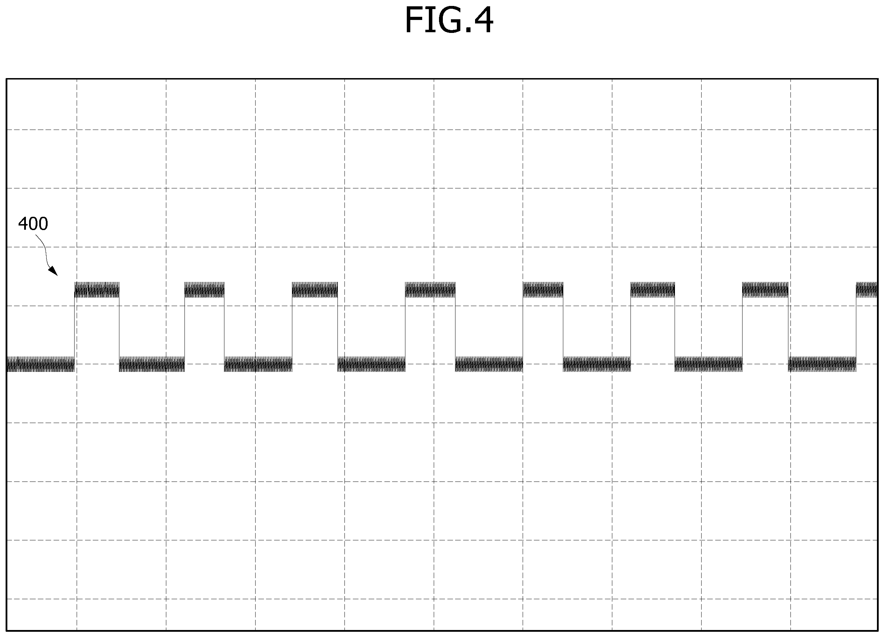

FIG. 4 is an diagram illustrating a waveform of an on/off duty (duty) control signal 400 resulting from each balancing switch $SW_1$ to $SW_n$ of the switching module 320 for controlling the cell balancing current by reflecting the resistance value X of each balancing resistor $RS_1$ to $RS_n$ of the resistor module 330. The resistance value X of each balancing resistor $RS_1$ to $RS_n$ of the resistor module 330 depends on the length of the flat cable 200 to the tap 210 associated with the resistor $RS_1$ to $RS_n$, which reflects the FlatCable resistance R = CR (cable resistance value) depending on the length to each tap 210 of the flat cable 200 in FIG. 3.

The processor 310 controls the on/off duty of each balancing switch $SW_1$ to $SW_n$ of the switching module 320 to control the cell balancing current by reflecting the resistance value X of each balancing resistor $RS_1$ to $RS_n$ of the resistor module 330 and the resistance value depending on the length to each tap 210 of the flat cable 200 (that is, the FlatCable resistance R=CR) (see FIG. 4).

Thus, according to some embodiments, the cell balancing current is controlled through control of the on/off duty of each balancing switch $SW_1$ to $SW_n$ of the switching module 320 by reflecting the resistance value (that is, the FlatCable resistance R=CR) depending on the length to each tap 210 of the flat cable 200 connected to each individual cell 105 of the battery 100. This control may improve the cell balancing efficiency.

As noted, when a conventional on/off duty control method, which may be sufficient for use with a wire with no significant difference in resistance value depending on length, is applied when the flat cable is used, the cell balancing current may decrease due to resistance of the flat cable and, thus, the cell balancing efficiency may be lowered. This decrease may be different for different cells based on the length of the flat cable to the cell. According to embodiments detailed herein, the cell balancing current is controlled through control of the on/off duty of each balancing switch $SW_1$ to $SW_n$ so that the on/off duty is different for each individual cell 105 and reflects the resistance value associated with the cell 105 based on the length of the flat cable 200 (tap 210) to the cell 105. Thus, the cell balancing efficiency may be improved according to one or more embodiments.

According to a conventional cell balancing control method, by which a controller controls the cell balancing current using only the resistance value X' of each balancing resistor, which does not reflect the FlatCable resistance R=CR, which depends on the length of the flat cable, or the conventional wire with no significant difference in resistance value depending on the length is used, a balancing average current is simply controlled by "V/X'*duty," where X' is a resistance value, which does not reflect CR, and the same duty cycle is applied for each cell.

According to some embodiments, improvement in cell balancing efficiency may be achieved by controlling the duty ratio of the switching module 320 for controlling the cell balancing current to be different for each individual cell 105 by reflecting the resistance value of the flat cable 200 specific to the cell 105 based on the length of the flat cable 200 to the cell 105.

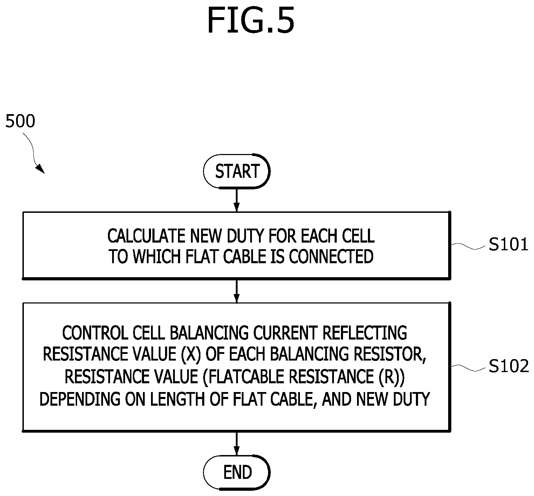

FIG. 5 is a process flow of a method 500 of controlling the cell balancing current based on the resistance value of the flat cable 200 to each cell 105, according to some embodiments.

Referring to FIG. 5, at S101, the processor 310 may calculate a "New duty" (that is, hereinafter, a new duty set to be distinguished from the conventional duty cycle for controlling a cell balancing current) for each cell 105 to which the flat cable 200 is connected according to EQ. 1.

$$\text{New duty} = (X + \text{FlatCable R})/X * \text{duty} \qquad \text{EQ. 1}$$

Here, X is the resistance value of each balancing resistor $RS_1$ to $RS_n$, "FlatCable R" is a resistance value (CR) associated with the flat cable 200, and duty is the duty ratio value that does not reflect the resistance value that depends on the length of the flat cable 200.

For example, assuming that the processor 310 calculates the "New duty" for two cells 105 using EQ. 1, the New duty (A1 for one cell 105 (cell 1) and A2 for the other cell 105 (cell 2)) may be calculated as shown in EQs. 2 and 3:

$$A1 = (RS_1 + CR_1)/\, RS_1 * A \qquad\qquad EQ.\ 2$$

$$A2 = (RS_2 + CR_2)/\, RS_2 * A \qquad\qquad EQ.\ 3$$

In EQs. 2 and 3, A is a conventional cell duty that does not reflect the resistance value of the flat cable 200 (that is, a duty considering only the balancing resistor and a switch temperature), $RS_1$ and $RS_2$ are balancing resistors respectively connected to cell 1 and cell 2, and

$CR_1$ and $CR_2$ are resistances associated with the flat cable 200 based on the respective length of the flat cable 200 to cell 1 and cell 2.

At S102, the processor 310 may control the cell balancing current according to EQ. 4 by reflecting the resistance value X of each balancing resistor $RS_1$ to $RS_n$ connected to each cell 105, the resistance value of the flat cable 200, based on the length of the flat cable 200 to each tap 210 of the flat cable 200, and the New duty, which reflects the resistance value depending on the length of the flat cable 200.

$$\text{Cell balancing voltage} = (V/X + \text{FlatCable R})/\text{New duty} \qquad EQ.\ 4$$

In EQ. 4, V is a cell voltage, X is the resistance value of the balancing resistor $RS_1$ to $RS_n$ associated with the cell 105, the FlatCable R is the resistance value (CR) of the flat cable 200 based on the length of the flat cable 200 to the cell 105, and New duty is a duty value reflecting the resistance value of the flat cable 200.

Hereinafter, to help understanding the present disclosure, an embodiment will be described.

For example, assuming that a 4 V cell is cell-balanced with a cell balancing resistance of 4 $\Omega$, a current of about 1 A may flow.

In this case, a cell balancing current is switched through a switching module 320, and an on/off duty of the switching module 320 is controlled for each individual cell, but a difference in the duty for each cell is set by reflecting a resistance value depending on a cable length of a flat cable 200 which connects to each cell 105 of a battery 100.

Thus, as the on/off duty of the switching module 320 for controlling the cell balancing current for each cell is optimized for each cell 105, the cell balancing efficiency may be improved.

As described above, in the embodiment, as an on/off duty ratio of a switching module for applying a cell balancing current can be controlled to be different for each cell 105 by reflecting a resistance value depending on a length of a flat cable 200 which connects each cell 105 of a multi-series battery 100 and a battery management system (BMS) 300, there is an effect capable of improving the cell balancing efficiency.

According to one aspect of the present disclosure, an on/off duty ratio of a switching module 320 for applying a cell balancing current can be controlled to be different for each individual cell 105 by reflecting a resistance value depending on a length of a flat cable 200 which connects each cell 105 of a multi-series battery 100 and a battery management system (BMS) 300.

However, effects that can be achieved through the present invention are not limited to the above-described effects and other effects that are not described may be clearly understood by those skilled in the art from the detailed descriptions.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

The embodiments described in this specification and the configurations shown in the drawings are only some of one or more embodiments of the present disclosure and do not represent all of the aspects of the present disclosure. Accordingly, it should be understood that there may be various equivalents and modifications that can replace or modify one or more embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

**In** the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same". Thus, the phrase "substantially the same" may include a case having a deviation that is considered low in the art, for example, a deviation of 5% or less. **In** addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Embodiments are set out in the following clauses:

Clause 1. A cell balancing current control device of a battery cell connected to a battery management system (BMS) with a flat cable,

wherein the BMS includes at least one processor, and
the processor reflects a resistance value depending on a length of the flat cable to control an on/off duty of a switching module for controlling a cell balancing current for each cell, for each individual cell.

Clause 2. The cell balancing current control device of clause 1, wherein:

the flat cable includes a plurality of taps for connecting each cell of a battery at designated intervals; and
there is a difference in resistance value depending on a cable length from the connector to each tap of the flat cable.

Clause 3. The cell balancing current control device of clause 1 or 2, wherein a resistor module including a plurality of balancing resistors ($RS_1$ to $RS_n$) each having a resistance value (X) set for applying a cell balancing current and a switching module including a plurality of balancing switches ($SW_1$ to $SW_n$) for controlling the cell balancing current are formed between the processor and the flat cable.

Clause 4. The cell balancing current control device of any preceding clause, wherein the processor reflects a resistance value (X) of each balancing resistor ($RS_1$ to $RS_n$) of a resistor module and the resistance value depending on a length to each tap of the flat cable to control the cell balancing current through control of the on/off duty of each balancing switch ($SW_1$ to $SW_n$) of the switching module.

Clause 5. The cell balancing current control device of any preceding clause, wherein the processor calculates a duty (New duty) for cell balancing current control for each cell to which the flat cable is connected, and reflects the resistance value depending on the length of the flat cable to which each cell is connected to calculate the duty (New duty) for each cell.

Clause 6. The cell balancing current control device of clause 5, wherein the processor calculates the duty (New duty) for each cell using the following Equation 1,

$$(\text{Equation 1})$$

$$\text{duty (New duty)} = (X + \text{FlatCable R})/X * \text{duty},$$

here, X is a resistance value of each balancing resistor ($RS_1$ to $RS_n$),
FlatCable R is a resistance value (CR) of the flat cable, and
duty is a duty value that does not reflect the resistance value of the flat cable.

Clause 7. The cell balancing current control device of clause 1, wherein, in order to control the cell balancing current for each cell to which the flat cable is connected, the processor calculates a duty (New duty) for each cell that reflects the resistance value depending on the length of the flat cable to which each cell is connected, and reflects a resistance value (X) of each balancing resistor ($RS_1$ to $RS_n$) connected to each cell and a resistance value (FlatCable R) depending on the length of the flat cable to control the cell balancing current.

Clause 8. The cell balancing current control device of clause 7, wherein the processor controls each cell balancing current using the following Equation 2,

(Equation 2)

$$\text{cell balancing current} = (V/(X+\text{FlatCable R}))*\text{New duty}$$

here, V is a cell voltage,

X is a resistance value of each balancing resistor ($RS_1$ to $RS_n$),

FlatCable R is the resistance value (CR) of the flat cable, and

New duty is a duty value reflecting the resistance value of the flat cable.

Clause 9. A cell balancing current control method of a battery cell connected to a battery management system (BMS) with a flat cable, the cell balancing current control method comprising:

reflecting, by a processor of the BMS, a resistance value depending on a length of the flat cable to calculate an on/off duty of a switching module; and

performing, by the processor, cell balancing current control based on the on/off duty of the switching module calculated by reflecting the resistance value depending on the length of the flat cable.

Clause 10. The method of clause 9, wherein, in the reflecting of the resistance value depending on the length of the flat cable,

the flat cable includes a plurality of taps for connecting each cell of a battery at designated intervals, and there is a difference in resistance value depending on a cable length from a connector to each tap of the flat cable.

Clause 11. The method of clause 9 or clause 10, wherein a resistor module including a plurality of balancing resistors ($RS_1$ to $RS_n$) each having a resistance value (X) set for applying a cell balancing current and a switching module including a plurality of balancing switches ($SW_1$ to $SW_n$) for controlling the cell balancing current are formed between the processor and the flat cable.

Clause 12. The method of any one of clauses 9 to 11, wherein, in the performing of the cell balancing current control, the processor reflects a resistance value (X) of each balancing resistor ($RS_1$ to $RS_n$) of the resistor module and the resistance value depending on a length to each tap of the flat cable to control the cell balancing current through the on/off duty control of each balancing switch ($SW_1$ to $SW_n$) of the switching module.

Clause 13. The method of any one of clauses 9 to 12, wherein, in the calculating of the on/off duty of the switching module, the processor calculates a duty (New duty) for the cell balancing current control for each cell to which the flat cable is connected, and reflects the resistance value depending on the length of the flat cable to which each cell is connected to calculate the duty (New duty) for each cell.

Clause 14. The method of clause 13, wherein the processor calculates the duty (New duty) for each cell using the following Equation 1,

(Equation 1)

$$\text{duty (New duty)} = (X+\text{FlatCable R})/X*\text{duty},$$

here, X is a resistance value of each balancing resistor ($RS_1$ to $RS_n$),

FlatCable R is a resistance value (CR) of the flat cable, and

duty is a duty value that does not reflect the resistance value of the flat cable.

Clause 15. The method of any one of clauses 9 to 14, wherein, in the performing of the cell balancing current control, in order to control the cell balancing current for each cell to which the flat cable is connected, the processor calculates a duty (New duty) for each cell that reflects the resistance value depending on the length of the flat cable to which each cell is connected, and reflects a resistance value (X) of each balancing resistor ($RS_1$ to $RS_n$) connected to each cell and a resistance value (FlatCable R) depending on the length of the flat cable to control the cell balancing current.

Clause 16. The method of clause 15, wherein the processor controls each cell balancing current using the following Equation 2,

(Equation 2)

$$\text{cell balancing current} = (V/(X+\text{FlatCable R}))*\text{New duty}$$

here, V is a cell voltage,
X is a resistance value of each balancing resistor ($RS_1$ to $RS_n$),
FlatCable R is the resistance value (CR) of the flat cable, and
New duty is a duty value that does not reflect the resistance value of the flat cable.

Clause 17. A battery pack comprising:

a plurality of battery cells; and
a flat cable that connects a battery management system (BMS) and each of the plurality of battery cells,
wherein at least one processor of the BMS performs cell balancing current control for each cell based on a duty
calculated by reflecting a resistance value depending on a length of the flat cable.

**Claims**

1. A cell balancing current control device of cells of a battery implemented by a battery management system (BMS)
connected to the cells with a flat cable,
the cell balancing current control device comprising:

a switching module for controlling a cell balancing current for each cell; and
at least one processor configured to use a resistance value of the flat cable, that depends on a length of the flat
cable, to control an on/off duty of the switching module, for each individual cell.

2. The cell balancing current control device of claim 1, wherein:

the flat cable includes a plurality of taps for connecting to cells of the battery at respective designated intervals;
and
there is a difference in resistance value associated with each tap depending on a cable length from a connector to
each tap of the flat cable.

3. The cell balancing current control device of claim 1 or claim 2, further comprising:

a resistor module including a plurality of balancing resistors ($RS_1$ to $RS_n$), wherein each of the balancing resistors
($RS_1$ to $RS_n$) has a resistance value (X) set for applying a cell balancing current; and
a switching module including a plurality of balancing switches ($SW_1$ to $SW_n$) between the at least one processor
and the flat cable configured to control the cell balancing current.

4. The cell balancing current control device of any preceding claim, wherein the processor reflects a resistance value (X)
of each balancing resistor ($RS_1$ to $RS_n$) of a resistor module, the resistance value depending on the length of the flat
cable to each tap, to control the cell balancing current through control of the on/off duty of each balancing switch ($SW_1$
to $SW_n$) of a switching module.

5. The cell balancing current control device of any preceding claim, wherein the processor calculates a duty (New duty)
for cell balancing current control for each cell to which the flat cable is connected, and reflects the resistance value of
the flat cable, which depends on the length of the flat cable to which each cell is connected, to calculate the duty (New
duty) for each cell.

6. The cell balancing current control device of claim 5, wherein the processor calculates the duty (New duty) for each cell
as:

$$\text{New duty}=(X+\text{FlatCable R})/X*\text{duty},$$

where, X is a resistance value of each balancing resistor ($RS_1$ to $RS_n$) that reflects the resistance value of the flat cable associated with each balancing resistor ($RS_1$ to $RS_n$),
FlatCable R is the resistance value of the flat cable based on the length of the flat cable, and
duty is a duty value that does not reflect the resistance value of the flat cable.

7. The cell balancing current control device of any preceding claim, wherein, in order to control the cell balancing current for each cell to which the flat cable is connected, the processor calculates a duty (New duty) for each cell that reflects the resistance value depending on the length of the flat cable to which each cell is connected, and reflects a resistance value (X) of each balancing resistor ($RS_1$ to $RS_n$) connected to each cell and a resistance value (FlatCable R) depending on the length of the flat cable to control the cell balancing current.

8. A cell balancing current control method for cells of a battery connected to a battery management system (BMS) with a flat cable, the cell balancing current control method comprising:

   reflecting, by a processor of the BMS, a resistance value depending on a length of the flat cable to calculate an on/off duty of a switching module; and
   performing, by the processor, cell balancing current control based on the on/off duty of the switching module calculated by reflecting the resistance value depending on the length of the flat cable.

9. The method of claim 8, wherein, in the reflecting of the resistance value depending on the length of the flat cable,

   the flat cable includes a plurality of taps for connecting cells of the battery at respective designated intervals, and
   there is a difference in resistance value depending on a cable length from a connector to each tap of the flat cable.

10. The method of claim 8 or claim 9, wherein a resistor module including a plurality of balancing resistors ($RS_1$ to $RS_n$) each having a resistance value (X) set for applying a cell balancing current and a switching module including a plurality of balancing switches ($SW_1$ to $SW_n$) for controlling the cell balancing current are formed between the processor and the flat cable.

11. The method of any one of claims 8 to 10, wherein, in the performing of the cell balancing current control, the processor reflects a resistance value (X) of each balancing resistor ($RS_1$ to $RS_n$) of a resistor module and the resistance value depending on a length to each tap of the flat cable to control the cell balancing current through the on/off duty control of each balancing switch ($SW_1$ to $SW_n$) of a switching module.

12. The method of any one of claims 8 to 11, further comprising calculating the on/off duty of the switching module by calculating a duty (New duty) for the cell balancing current control for each cell to which the flat cable is connected, and reflecting the resistance value depending on the length of the flat cable to which each cell is connected.

13. The method of claim 12, wherein calculating the duty (New duty) for each cell is according to:

$$\text{duty (New duty)}=(X+\text{FlatCable R})/X*\text{duty},$$

   where, X is a resistance value of each balancing resistor ($RS_1$ to $RS_n$),
   FlatCable R is a resistance value of the flat cable, and
   duty is a duty value that does not reflect the resistance value of the flat cable.

14. The method of any one of claims 8 to 13, wherein, in the performing of the cell balancing current control, in order to control the cell balancing current for each cell to which the flat cable is connected, the processor calculates a duty (New duty) for each cell that reflects the resistance value depending on the length of the flat cable to which each cell is connected, and reflects a resistance value (X) of each balancing resistor ($RS_1$ to $RS_n$) connected to each cell and a resistance value (FlatCable R) depending on the length of the flat cable to control the cell balancing current.

15. A battery pack comprising:

   a plurality of battery cells;
   a battery management system (BMS); and
   a flat cable that connects the BMS and each of the plurality of battery cells,
   wherein at least one processor of the BMS performs cell balancing current control for each cell based on a duty calculated by reflecting a resistance value of the flat cable depending on a length of the flat cable.

# FIG.1

EP 4 686 039 A1

FIG.2

# FIG.3

EP 4 686 039 A1

FIG.4

# FIG.5

500

START

CALCULATE NEW DUTY FOR EACH CELL
TO WHICH FLAT CABLE IS CONNECTED — S101

CONTROL CELL BALANCING CURRENT REFLECTING
RESISTANCE VALUE (X) OF EACH BALANCING RESISTOR,
RESISTANCE VALUE (FLATCABLE RESISTANCE (R))
DEPENDING ON LENGTH OF FLAT CABLE, AND NEW DUTY — S102

END

Europäisches
Patentamt

European
Patent Office

Office européen
des brevets

## EUROPEAN SEARCH REPORT

**Application Number**

EP 25 18 0851

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 2017 212832 A (MITSUBISHI ELECTRIC CORP) 30 November 2017 (2017-11-30) * paragraphs [0070] - [0076]; figure 2 * ----- | 1-15 | INV. H02J7/00 B60L58/22 |
| Y | SIQI LI ET AL: "A high efficiency low cost direct battery balancing circuit using a multi-winding transformer with reduced switch count", APPLIED POWER ELECTRONICS CONFERENCE AND EXPOSITION (APEC), 2012 TWENTY-SEVENTH ANNUAL IEEE, IEEE, 5 February 2012 (2012-02-05), pages 2128-2133, XP032127959, DOI: 10.1109/APEC.2012.6166115 ISBN: 978-1-4577-1215-9 * page 2 -labelled 2129-, right column, first paragraph, 3rd to 5th sentences * ----- | 1-15 | ADD. H01B7/08 |

**TECHNICAL FIELDS SEARCHED (IPC)**

H02J
B60L
H01M

The present search report has been drawn up for all claims

| Place of search | Date of completion of the search | Examiner |
|---|---|---|
| Munich | 23 October 2025 | Varela Fraile, Pablo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 0851

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2025

| Patent document cited in search report | Publication date | Patent family member(s) | Publication date |
|---|---|---|---|
| JP 2017212832 A | 30-11-2017 | JP 6422466 B2<br>JP 2017212832 A | 14-11-2018<br>30-11-2017 |

For more details about this annex : see Official Journal of the European Patent Office, No. 12/82

EPO FORM P0459